# EUROPÄISCHE PATENTSCHRIFT

(11) **EP 0 533 044 B1**
(45) Veröffentlichungstag und Bekanntmachung des Hinweises auf die Patenterteilung: **29.12.1999**
(21) Anmeldenummer: 92115397.9
(22) Anmeldetag: 09.09.1992
(51) Int. Cl.: C23C 16/50, C23C 16/40, H01J 37/32

(54) **Verfahren zur Schutzbeschichtung von Substraten sowie Beschichtungsanlage**
Process and apparatus for the protective coating of substrates
Procédé et dispositif pour fabrication de revêtements protecteurs sur des substrats

(30) Priorität: 20.09.1991 CH 279391
(43) Veröffentlichungstag der Anmeldung: 24.03.1993
(73) Patentinhaber: BALZERS AKTIENGESELLSCHAFT, 9496 Balzers (LI)
(72) Erfinder: Jost, Stephan, CH-9477 Trübbach (CH); Senn, Leonhard, FL-9493 Mauren (LI)
(74) Vertreter: Troesch Scheidegger Werner AG

(56) Entgegenhaltungen:
- EP-A- 0 207 767
- EP-A- 0 299 754
- EP-A- 0 346 055
- DD-A- 272 773
- FR-A- 2 169 072
- Applied Physics Letter, Band 53, Nr. 14, 03.10.98, Seiten 1263-1265, Watanabe Y. et al.

## Beschreibung

Die vorliegende Erfindung betrifft ein Verfahren zur Schutzbeschichtung von Substraten mittels Plasmapolymerisation sowie ein System hierfür.

Es ist aus der Schutzschichttechnologie bekannt, Substrate, insbesondere nichtplane Substrate, wie Reflektoren für Scheinwerfer, so z.B. für Autoscheinwerfer, Beleuchtungskörper etc., mit korrosionsfesten bzw. wischfesten, reflektierenden Schutzschichten zu versehen.

Bei der hierzu bekannterweise eingesetzten Plasmapolymerisation, einem plasmaunterstützten, chemischen Beschichtungsverfahren bei vergleichsweise tiefen Substrattemperaturen, werden derartige metallische Substrate oder vorgängig metallbeschichtete, insbesondere aluminiumbedampfte Substrate, mit Siloxan, einer Silizium-organischen Verbindung, beschichtet.

Da hierzu, wie z.B. aus der DE-OS-22 63 480 oder der FR-A- 2 169 072 bekannt, das Plasma mit Gleichspannung erzeugt wird, ergibt sich die Notwendigkeit, nach jedem Beschichtungsvorgang mindestens eine der hierzu eingesetzten metallischen Elektroden, zwischen welchen das Plasma erzeugt wird, neu mit einer Metallumhüllung zu versehen, weil während der Beschichtung mit Siloxan auf der Elektrode eine isolierende Schicht gebildet wird mit relativ hoher Beschichtungsrate, so dass ohne den genannten Wechsel der Metallumhüllung sich mehr und mehr eine dielektrische Schicht auf der Elektrode ausbildet. Dies würde zu einem unstabilen Plasma führen mit Durchschlägen durch die sich ausbildende Isolationsschicht, Kontamination des Beschichtungsraumes durch Absprühen, bis schliesslich zum Unterbruch der Plasmaentladung.

Diese Problematik bleibt bestehen, wenn, gemäss der DD-A- 272 773, ein gepulstes DC-Plasma eingesetzt wird. Gemäss dieser Schrift wird nämlich eine netzfrequente Wechselspannung, einweggleichgerichtet, zur Plasmaerzeugung verwendet. Mittels einer überlagerten DC-Spannung wird die Gesamtspannung während Entladungsphasen erhöht, wodurch die Produktivität erhöht werde. Dabei sei der überlagerten DC-Spannung dort ein Grenzwert gesetzt, wo die Entladung in eine Dauerentladung übergehe. Das pulsierende Ein- und Ausschalten einer Entladung mit nur monopolarer Betriebsspannung (Gleichrichtung) entspricht aber einem gepulsten DC-Entladungsbetrieb. Zweck der hier vorgeschlagenen gepulsten DC-Entladung ist das Verhindern von Funkenbildung, wie sie bei reinem DC-Betrieb bekanntlich oft auftritt.

Durch die Notwendigkeit, die erwähnte Elektrode jeweils neu zu umhüllen, ergeben sich relativ lange Wartungsintervalle, wodurch die Produktionsanlage längere Zeit und öfter ausser Betrieb gesetzt werden muss. Dies ist z.B. bei Durchlaufproduktionsanlagen nicht tolerierbar. Zur Oberflächenbearbeitung - sei dies Aetzen oder Beschichten - durch ein reaktives, plasmaunterstütztes Verfahren, ist es aus der EP-A-207 767 bekannt, ein Hf-Plasma zu pulsen.

Ohne Präferenz sind, für die Beschichtung, viele mögliche Materialien erwähnt, wie Si₃N₄, TiO₂, Al₂O₃, BN, SiO₂, B₄C, SiC, WC, Tic, TiN, BP. All diese Beschichtungsmaterialien werden nicht durch Polymerisation gebildet.

Verfahrensparameter bei der Plasmapolymerisation hängen aber sehr stark von der jeweiligen verwendeten Verbindung ab.

Es ist bei der Plasmapolymerisation auch von Silizium-organischen Verbindungen - so aus der EP-A- 0 299 754 - bekannt, das Plasma mit einem elektromagnetischen Wechselfeld zu erzeugen. In dieser Schrift wird zwischen dem Einsatz Silizium-organischer und Silizium-anorganischer Verbindungen unterschieden.

Bei gewissen eingesetzten nicht Silizium-organischen gasförmigen Verbindungen, wie Methan, wird am andern Ort festgestellt, dass bei Pulsen des elektromagnetischen Wechselfeldes, bei gleicher zugeführter mittlerer elektrischer Leistung, höhere Abscheidungsraten erzielt werden.

Wie sich - wie erwähnt - ein Beschichtungsprozess in Abhängigkeit von einer Plasma-Modulation aber verhält, hängt in starkem Masse von der spezifisch für die Beschichtung zugeführten, gasförmigen Verbindung ab.

Mit Bezug auf die Erkenntnis, dass mit einem gepulsten, elektromagnetischen Wechselfeld zur Erzeugung des Plasmas, bei gleicher zugeführter, mittlerer elektrischer Leistung und auch sonst gleichen Prozessbedingungen in gewissen Fällen höhere Beschichtungsraten erzielbar sind, sei verwiesen auf:
- Vinzant J, Shen M, Bell A, ACS SYMP.SER;SHEN BELL 108 p. 79 (1979), "Polymerization of Hydrocarbons in a pulsed plasma";
- H. Yasuda, T. Hsu: J.Polym Sci, Polym Chem ed 15,81, (1977), oder
- H. Yasuda "Plasma polymerization" Academic press (1985), p. 103-105;
- Lloret A, Bertran E, Andujar J, Canillas A, Morenza J, J.APPL.PHYS. 69, p. 632 (1991), "Ellipsometric study of a-Si:H thin films deposited by square wave modulated rf glow discharge".

Dass im weiteren mit dem Einsatz eines gepulsten elektromagnetischen Wechselfeldes zur Plasmaerzeugung eine kleinere Wärmebelastung des Substrates erfolgt, ergibt sich aus:
- GB-A-2 105 729 (1981), ITT Industries Ltd., London-GB;
- US-A-4 950 956 (1990), Anelva Corp., Tokyo, Japan.

Im weiteren ist es auch bekannt, dass bei Einsatz eines gepulsten elektromagnetischen Wechselfeldes zur Plasmaerzeugung neue Schichteigenschaften entstehen.

Es sei hierzu verwiesen auf
- JP-62 103 371 (1985), Hitachi KK;
- DD-264 344 A3 (1986), VEB ZFT Mikroelektronik.

Die Erhöhung der Schichtreinheit bzw. Verringerung pulverförmiger Schichtanteile ist bekannt
- bezogen auf Diamant- bzw. Graphitabscheidung aus Methan, aus: JP-62 123 096 (1985), Showa Denko KK;
- für die Siliziumanorganische Verbindung Silan (SiH₄) mittels plasmaerzeugendem, modulierten Hf-Wechselfeld aus: Watanabe Y, Shiratani M, Kubo Y, Ogawa I, Ogi S, APPL.PHYS.LETT. 53, p. 1263 (1988), "Effects of low frequency modulation on rf-discharge chemical vapor deposition";
- mit Bezug auf die Abscheidung amorphen Kohlenstoffes aus Methan aus: Hossary F, Fabian D, Webb A, THIN SOL.FILM 192, p. 201 (1990), "Optical properties of amorphous carbon films formed by rf-plasma-deposition from methane";
- wiederum mit Bezug auf Silan (SiH₄) sei weiter Bezug genommen auf: Watanabe Y, Shiratani M, Makino H, APPL.PHYS.LETT. 57, p. 1616 (1990), "Powder-free plasma chemical vapor deposition of hydrogenated amorphous Silicon with high rf power density using modulated rf discharge".

Ziel der vorliegenden Erfindung ist es, ein Verfahren zur Erzeugung einer Schutzbeschichtung mittels Plasmapolymerisation einer gasförmigen Silizium-organischen Verbindung, zu schaffen, bei dem die erwähnte "Elektroden-Wartung" nicht mehr vorgenommen werden muss und bei dem weiter eine möglichst hohe Beschichtungsrate, ohne dass sich pulverförmige Schutzschichtanteile auf dem Substrat niederschlagen würden, erzielbar ist.

Dies wird bei Vorgehen nach Anspruch 1 erreicht.

Es wurde mithin gefunden, dass bei der Plasmapolymerisationsabscheidung Silizium-organischer Verbindungen, bei Plasmaerzeugung mittels gleichspannungsfreier Periodisch amplitudenmodulierter elektromagnetischer Wechselfelder, die erwähnte Aufgabe, sowohl was Elektroden-Wartung anbelangt, gelöst wird und dass, hinzukommend, die Beschichtungsrate durch entsprechendes Stellen eines Verfahrensparameters wesentlich erhöht werden kann, ohne dass die erzeugte Schutzschicht an sich zu erwartende pulverförmige Anteile aufwiese. Solche Anteile treten aber bei Stillsetzung der Amplitudenmodulation am elektromagnetischen Wechselfeld unmittelbar wieder auf, und zwar auch, wenn der erwähnte Parameter, z.B. die mittlere zugeführte Leistung, und mit ihm die Beschichtungsrate, wieder stark reduziert wird.

Während es bekannt war, dass bei gewissen Monomeren, speziell mit Doppelbindungen, eine Amplitudenmodulation des das Plasma erzeugenden Wechselfeldes, wozu die Pulsung des Wechselfeldes ein Spezialfall bildet, mit Wechselfeldfrequenzen (Träger) von Hochfrequenz bis in den Mikrowellenbereich, eine höhere Rate erreicht wird, bei gleichbleibender mittlerer, zugeführter elektrischer Leistung und auch sonst gleichbleibenden Prozessparametern, und während es auch bekannt war, dass für Silan (SiH₄) und Kohlenwasserstoffe Schichtverunreinigungen durch Einsatz gepulster, Plasma-erzeugender Wechselfelder reduziert wird, wurde mithin erst erfindungsgemäss erkannt, dass bei der erfindungsgemässen Plasmapolymerisation mit Silizium-organischen Verbindungen sich die Abscheidungsrate durch Erhöhung eines entsprechenden Verfahrensparameters, wie der erwähnten zugeführten, mittleren elektrischen Leistung, wesentlich erhöhen lässt, ohne dass sich die für Silizium-anorganische Verbindungen bekannte (Silan) Schichtverunreinigung ergäbe.

Dem Wortlaut von Anspruch 2 folgend, kann die Amplitudenmodulation des elektromagnetischen Wechselfeldes zur Plasmaerzeugung durch Amplitudenmodulation eines Wechselsignalgenerators realisiert werden und/ oder durch getaktetes Aufschalten von mindestens zwei Wechselsignalgeneratoren unterschiedlicher Signalamplitude und/oder durch getaktetes Umschalten der Wechselsignaleinkopplung von einem Wechselsignalgenerator in die Vakuumkammer, so beispielsweise durch getaktetes Wechseln der Leistungseinkopplung von einem Mikrowellengenerator oder durch getaktetes Umschalten eines Hf-Wechselsignalgenerators auf unterschiedliche Elektrodenpaare, zwischen welchen das Plasma erzeugt wird.

Dem Wortlaut von Anspruch 3 folgend, wird die Beschichtungsrate vorzugsweise durch entsprechendes Stellen der zugeführten elektrischen Leistung und-oder des Druckes und/oder Flusses der zugeführten gasförmigen Silizium-organischen Verbindung und/oder durch Erhöhung der Trägerfrequenz des amplitudenmodulierten Wechselfeldes erhöht.

Dem Wortlaut von Anspruch 4 folgend, wird dabei, in einer weiteren bevorzugten Ausführungsvariante, das Wechselfeld durch Ein- und Ausschalten des Ausgangssignals eines Wechselsignalgenerators amplitudenmoduliert, d.h. es werden Wechselsignalpakete zur Plasmaanregung erzeugt.

Dem Wortlaut von Anspruch 5 folgend, wird weiter bevorzugterweise die Modulationsfrequenz des Wechselfeldes konstant gehalten und vorzugsweise im Bereich zwischen 1Hz und 1kHz (je eingeschlossen) gewählt.

Als Trägerfrequenz gemäss Wortlaut von Anspruch 6 wird vorzugsweise eine Frequenz zwischen 1kHz (eingeschlossen) und Mikrowellenfrequenzen gewählt, wobei die konstruktive Realisation, im Mikrowellenbereich, über 0,5GHz (eingeschlossen) besonders einfach wird, im Hf-Bereich insbesondere zwischen 1kHz und 1MHz (je eingeschlossen). Ausserordentlich gute Resultate wurden bis anhin bei einer Trägerfrequenz zwischen 10kHz und 500kHz (je eingeschlossen) erzielt.

Dem Wortlaut von Anspruch 7 folgend, wird vorzugsweise dann, wenn das Plasma zwischen mindestens zwei Elektroden erzeugt wird, mindestens eine der Elektroden gegen den Plasmaentladungsraum hin dielektrisch umhüllt, was dank der Wechselfeldplasmaanregung ohne weiteres möglich ist. Damit wird erreicht, dass trotz einer sich gegebenenfalls ergebenden, dielektrischen Elektrodenbeschichtung nur wenig ändernde Impedanzverhältnisse an der Plasmaentladungsstrecke resultieren.

Weitere bevorzugte Ausführungsvarianten des erfindungsgemässen Verfahrens sind in den Ansprüchen 8 und 9 spezifiziert.

Insbesondere dem Wortlaut von Anspruch 10 folgend, ist es beim erfindungsgemässen Vorgehen möglich, ein nicht planes Substrat zu beschichten, vorzugsweise mit der Form eines Reflektors als ausgesprochen unplanes Substrat, wobei trotzdem eine gleichförmige pulverabscheidungsfreie Schutzbeschichtung möglich wird.

Dem Wortlaut von Anspruch 12 folgend, werden weiter bevorzugterweise mindestens eine der folgenden Silizium-organischen Verbindungen eingesetzt, nämlich Siloxane und/oder Alkyl-/Alkoxy-Silane, dabei insbesondere Hexamethyl-DiSiloxan bzw. DiEthoxy-DiMethyl-Silan.

Dem Wortlaut von Anspruch 13 folgend, hat es sich erwiesen, dass bevorzugterweise Hexamethyl-DiSiloxan als Verbindung eingesetzt wird, welche nämlich kostengünstig ist, ausserordentlich stabile Beschichtungsverhältnisse ergibt, ungefährlich ist und mithin ausserordentlich praktisch in der Verwendung.

Ein erfindungsgemässes System ist in Anspruch 15 Spezifiziert, bevorzugte Ausführungsvarianten in den Ansprüchen 16 bis 30.

Insbesondere dem Anspruch 16 folgend, wird zwischen einer Gasbehälteranordnung mit einer flüssigen Silizium-organischen Verbindung und der Kammer die flüssige Silizium-organische Verbindung in gasförmigen Zustand überführt; dies insbesondere auch, wenn, in bevorzugter Art und Weise nach Anspruch 19, die Gasbehälteranordnung Hexamethyl-DiSiloxan enthält.

Die Erfindung wird anschliessend beispielsweise anhand von Figuren erläutert.

Es zeigen:
- Fig. 1: schematisch eine Aufsicht auf ein erfindungsgemässes System zur Ausführung des erfindungsgemässen Verfahrens,
- Fig. 2: schematisch eine bevorzugte Gaszuführung am System nach Fig. 1 in Seitensicht,
- Fig. 3a bis 3c: schematisch verschiedene Möglichkeiten zur Erzeugung des erfindungsgemäss eingesetzten amplitudenmodulierten Wechselfeldes,
- Fig. 4: beispielsweise, verschiedene erfindungsgemäss eingesetzte Modulationsarten einer plasmaerzeugenden Wechselspannung mit der heute bevorzugten.

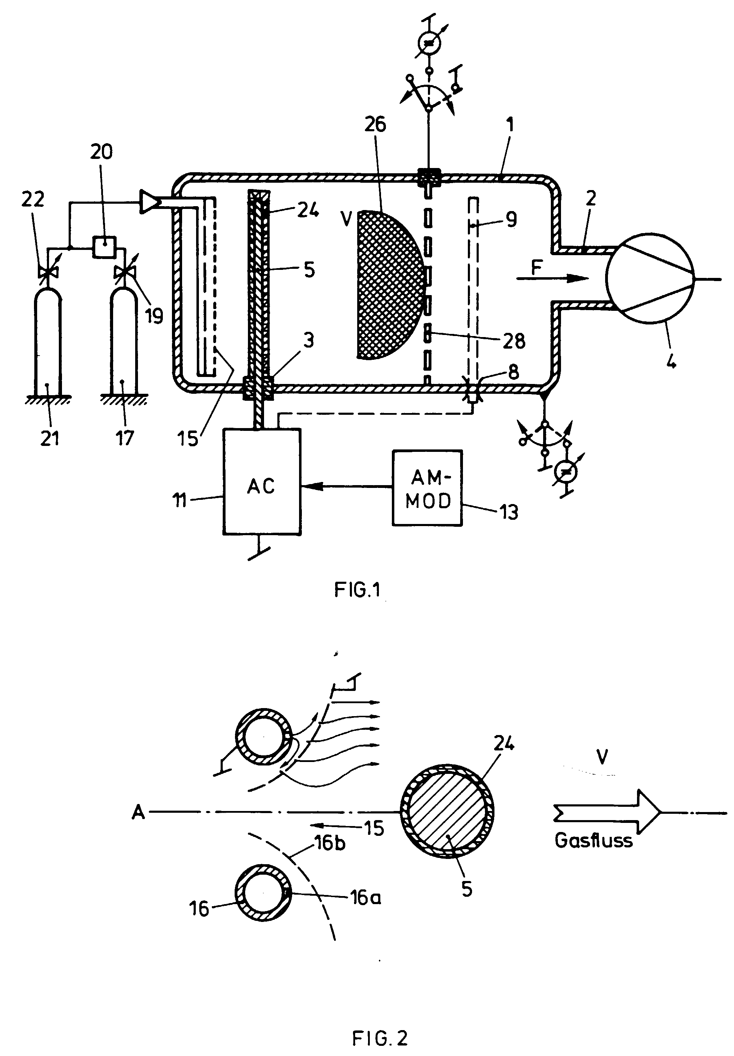

Gemäss Fig. 1 und 2 umfasst eine erfindungsgemässe Behandlungsanlage einen Vakuumrezipienten 1 mit einem Pumpanschluss 2, sowohl für die Evakuierung des Rezipienten 1 wie auch zur Aufrechterhaltung des Gasflusses in Pfeilrichtung durch den Rezipienten.

Im Rezipienten 1, diesbezüglich isoliert, wie schematisch bei 3 dargestellt, ist eine erste Elektrode 5 angeordnet, bevorzugterweise als Stabelektrode ausgebildet. Als Gegenelektrode wirkt entweder, wie dargestellt, mindestens ein Teil der Wandung 8 des Rezipienten 1, oder es ist, wie gestrichelt dargestellt, eine bezüglich des Rezipienten 1 isolierte Gegenelektrode 9 vorgesehen und das Gehäuse auf ein Referenzpotential, z.B. auf Massepotential, gelegt. Es können z.B. folgende Betriebsarten eingesetzt werden:
- ohne Elektrode 9:
   Gehäuse 8 auf Referenzpotential A:
   Halter 28 auf Referenzpotential A oder B = A oder
   Halter 28 potentialschwebend.
   Gehäuse 8 schwebend:
   Halter 28 auf Referenzpotential.
- mit Elektrode 9:
   Gehäuse 8 auf Referenzpotential A:
   Halter 28 auf Referenzpotential A oder B = A oder
   Halter 28 potentialschwebend oder
   Halter 28 auf einem Wechselpotential mitgeführt.
   Gehäuse 8 potentialschwebend:
   Halter 28 auf Referenzpotential oder
   Halter 28 potentialschwebend.

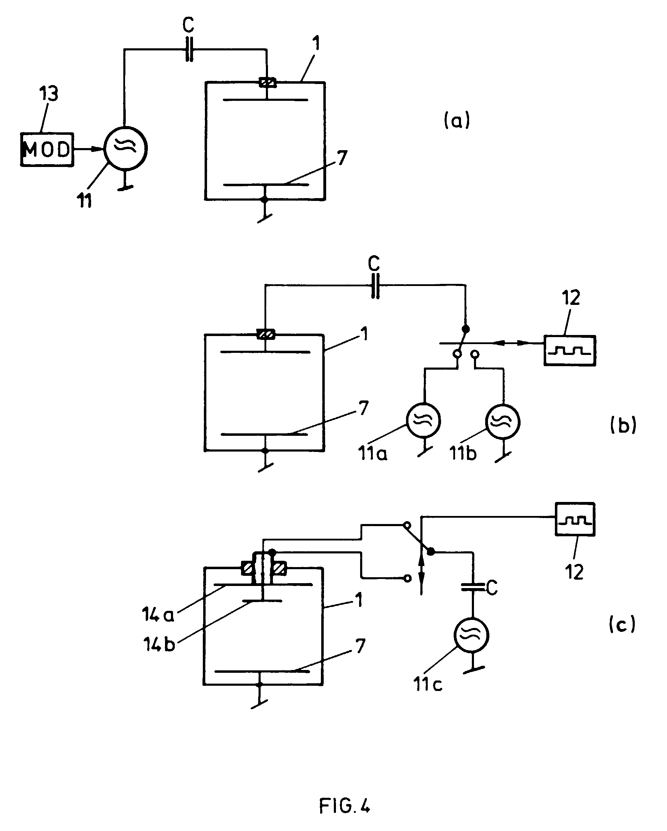

Grundsätzlich erfolgt die erfindungsgemässe Amplitudenmodulation des angelegten Wechselfeldes in einer der in Fig. 4 dargestellten Variante.

Gemäss Fig. 4a wird ein Wechselsignalgenerator 11 mittels einer Modulationseinheit 13 amplitudenmoduliert.

Gemäss Fig. 4b werden zwei oder gegebenenfalls mehr, vorzugsweise auf gleicher Frequenz, aber mit unterschiedlichen Amplituden betriebene Generatoren 11a, 11b vorgesehen und mittels einer Takteinheit 12 getaktet auf die Vakuumkammer 1 zur Plasmaerzeugung geschaltet.

Gemäss Fig. 4c wird ein einziger Wechselsignalgenerator llc durch eine Takteinheit 12 getaktet an unterschiedliche Plasmaentladungsstrecken 14a bzw. 14b in der Vakuumkammer 1 gelegt.

In Fig. 4 ist die entsprechende Technik für Trägerfrequenzen bis in den Hf-Bereich dargestellt. Es versteht sich von selbst, dass, im Mikrowellenbereich, entsprechende Mikrowellengeneratoren der Vakuumkammer 1 angekoppelt werden.

Im weiteren ist in Fig. 4 die eine der Elektroden 7 als mit dem Vakuumkammergehäuse verbunden und auf Bezugspotential, z.B. Massepotential, gelegt, dargestellt. Diese Elektroden 7 können auch bezüglich Vakuumkammergehäuse isoliert betrieben werden. Dann wird vorzugsweise das Gehäuse der Vakuumkammer 1 auf ein Referenzpotential, z.B. Massepotential, gelegt.

Mit Hilfe der eingetragenen Kapazitäten C wird die jeweilige Elektrode DC-mässig vom Generator entkoppelt, damit sie Schwebepotential einnehmen kann.

In Fig. 1 ist nun prinzipiell, dem Vorgehen nach Fig. 4a folgend, zwischen der Elektrode 5 und einer Gegenelektrode, sei dies die Wandung 8 des Rezipienten 1 oder eine isolierte Gegenelektrode 9, ein Wechselsignalgenerator 11 geschaltet, welcher eine Wechselspannung mit einer Frequenz zwischen 1kHz und Mikrowellenbereich (Mikrowellenbereich: 10⁹ Hz - 10¹² Hz) liefert, vorzugsweise zwischen 1kHz und 1MHz (beides eingeschlossen), im Mikrowellenbereich bzw. obern Hf-Bereich vorzugsweise über 0,5GHz (eingeschlossen).

Bei der heute verwendeten Anlage wird anlagespezifisch als Trägerfrequenz fₒ des Generators 11 370kHz eingesetzt.

Vorzugsweise wird im Hf-Bereich 10kHz ≤ fₒ ≤ 500kHz gewählt.

Bevorzugterweise wird weiter mit dem Modulationsgenerator 13 ein Ein-/Ausschalten der zwischen Elektrode 5 und Gegenelektrode 9 bzw. 7 angelegten Plasmaerregungs-Wechselspannung realisiert.

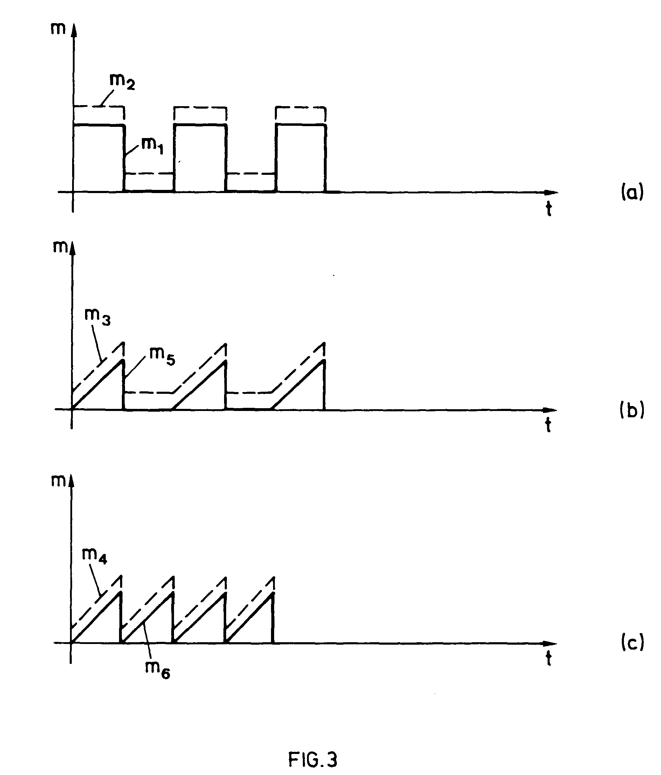

In Fig. 3 sind schematisch Modulationssignale m über der Zeitachse t dargestellt. Bevorzugterweise wird heute eine Rechteckmodulation der angelegten Wechselspannung, wie bei m₁ dargestellt, eingesetzt mit einem Pulstastverhältnis von 1 und mit einer Frequenz von 10Hz. Es ist aber durchaus möglich, wie mit der Rechteckmodulation bei m₂ gestrichelt dargestellt, zwischen einem Wechselspannungsmaximalwert und einem nicht verschwindenden Minimalwert zu modulieren, sei dies, wie gezeigt, rechteckförmig oder wie für Dreieckmodulationen bei m₃ bzw. m₄ dargestellt.

Bei den Modulationsarten gemäss m₅ und m₆ wird die Erregungswechselspannung wiederum zeitweise auf Null gesetzt.

Es versteht sich von selbst, dass sich nebst der bevorzugterweise eingesetzten und dargestellten Rechtecksmodulation und der ebenfalls dargestellten Dreiecksmodulation auch andere Modulationskurvenformen einsetzen lassen.

Bezüglich des Beschichtungsraumes V, zwischen der vorzugsweise wassergekühlten (nicht dargestellt) Elektrode 5 und Gegenelektrode 7 bzw. 9, hinter der Elektrode 5, ist ein bevorzugterweise brauseartiger Gaseinlass 15 vorgesehen, welcher einerseits mit einem Vorratsbehälter 17 für die Silizium-organische Verbindung, insbesondere für ein Siloxan, dabei insbesondere Hexamethyl-DiSiloxan, oder für ein Alkyl-/ Alkoxyl-Silan, dabei insbesondere ein DiEthoxy-DiMethyl-Silan, oder eine Mischung zweier oder mehrerer dieser Gase, verbunden ist, dies über einen Durchflussregler 19. Es kann anderseits ein Vorratsbehältnis 21 für ein Trägergas, wie Helium und/oder Argon und/oder Stickstoff, ebenfalls über einen Durchflussregler 22, auf den Gaseinlass 15 geführt sein.

Bevorzugterweise wird im Behältnis 17 Hexamethyl-DiSiloxan vorgesehen. Da die überwiegende Zahl erfindungsgemäss eingesetzter Verbindungen bei Raumtemperatur flüssig ist, wird meistens eine Verdampfungseinheit 20 vorgesehen bzw. die Verbindung flüssig in einem Tank bzw. Vorratsbehälter 17 bereitgestellt und in die Kammer 1 verdampft.

Wie in Fig. 2 dargestellt, umfasst der Gaseinlass vorzugsweise zwei oder mehr zur Elektrode 5 parallele, bezüglich Elektrode und Rezipientenachse A lateral versetzte Gaszuführbrausen 16 mit Oeffnungen 16a gegen den Raum V. Der Gaseinlass 15 liegt, in Gasflussrichtung betrachtet, stromauf der Elektrode 5. Mittels Gittern 16b wird eine erwünschte Gasverteilung erzielt, vorzugsweise lateral um die Elektrode 5 herum, und ein Zünden des Plasmas an den Oeffnungen 16a verhindert. Der Gaseinlass 15 ist vorzugsweise auf ein Bezugspotential, wie Massepotential, gelegt.

Bevorzugterweise ist weiter mindestens die eine der Elektroden, wie dargestellt Elektrode 5, mit einer isolierenden Umhüllung 24 versehen, womit eine Beschichtung während des Substratbeschichtungsvorganges die Impedanzverhältnisse an der Entladungsstrecke nicht mehr wesentlich ändern kann.

Als Substrat ist ein reflektorförmiges Substrat, z.B. ein metallisierter Scheinwerferreflektor, dargestellt. Das Substrat 26 ist im Beschichtungsraum V zwischen Elektrode 5 und Gegenelektrode 9 bzw. 7 positioniert, sei dies auf der Gegenelektrode 9 bzw. 7 bzw. auf einer damit galvanisch verbundenen Halterung oder sei dies, wie als bevorzugte Ausführungsvariante dargestellt, auf einem den Gasfluss nur wenig störenden, isolierenden Träger 28, d.h. potentialmässig im Behandlungsraum V frei schwebend.

Mit der dargestellten Anlage wurde das nachfolgend tabellierte Beispiel mit dem Vergleichsbeispiel realisiert. Es ergab sich am Vergleichsbeispiel eine stark milchige Beschichtung, mithin mit hohem pulverförmigem Anteil. Am erfindungsgemässen Beispiel war keine milchige Beschichtung erkennbar. Die verwendete Anlage war in beiden Fällen gleich, ebenso das beschichtete Substrat.

| | Beispiel | Vergleich |
|---|---|---|
| mittlere zugeführte Leistung (W) | 200W | 200W |
| Trägerfrequenz fₒ (kHz) | 370kHz | 370kHz |
| Gasdruck (µbar) | 50 | 50 |
| Reaktionsgasdurchfluss (sccm) | 130 | 130 |
| Reaktionsgas | HMDSO | HMDSO |
| Trägergasdurchfluss (sccm) | 170 | 170 |
| Trägergas | N₂ | N₂ |
| Modulationsart | Rechteck-Ein/Aus | nicht mod. |
| Modulationsfrequenz (Hz) | 10 | - |
| Duty cycle | 1 | - |
| Beschichtungsrate Å/sec | 20 | 20 |
| Milchigkeit | nichts | stark |
| Substrat | Al-beschichteter Reflektor | |
| Länge der aktiven Elektrode | 300mm | 300mm |
| kleinster Abstand zwischen aktivem Elektroden-Substrat | 40mm | 40mm |
| Durchmesser der aktiven Elektrode | 20mm | 20mm |
| Distanz Substrathalter(28)-aktive Elektrode (5) (mm) | 50 | 50 |
| HMDSO = HexamethylDiSiloxan | | |

Ohne Modulation ergab sich eine milchig aussehende Beschichtung bis hin zu deutlich pulverförmiger Abscheidung, und zwar bis hinunter auf 100W mittlerer zugeführter Leistung. Der Trägergasanteil an der Gesamtgasmenge beträgt vorzugsweise zwischen 0 und 80%.

## Patentansprüche

1. Verfahren zur Schutzbeschichtung von Substraten mittels Plasmapolymerisation mit mindestens einer gasförmigen siliziumorganischen Verbindung, bei dem ein Plasma in einer Vakuumkammer mittels eines gleichspannungsfreien elektromagnetischen Wechselfeldes erzeugt wird, ein Gas mit der Verbindung zugespiesen wird zur Erzeugung der Beschichtung und durch periodische Amplitudenmodulation des Wechselfeldes die Bildung pulverförmiger Anteile an der Schutzschicht weitestgehend verhindert wird.

2. Verfahren nach Anspruch 1, bei dem das elektromagnetische Wechselfeld nach einer oder, kombiniert, nach mindestens zwei der nachfolgenden Arten erzeugt wird:
a) durch Amplitudenmodulation eines Wechselsignalgenerators,
b) durch getaktetes Aufschalten von mindestens zwei Wechselsignalgeneratoren unterschiedlicher Signalamplitude,
c) durch getaktetes Umschalten der Wechselsignaleinkopplung von einem Wechselsignalgenerator in die Vakuumkammer.

3. Verfahren nach einem der Ansprüche 1 oder 2, bei dem die Beschichtungsrate mittels mindestens eines der folgenden Verfahrensparameter gestellt wird:
- zugeführte elektrische Leistung,
- Druck und/oder Fluss der gasförmigen, Silizium-organischen Verbindung,
- Trägerfrequenz eines das amplitudenmodulierte Wechselfeld erzeugenden Wechselsignals.

4. Verfahren nach einem der Ansprüche 1 bis 3, bei dem das Wechselfeld durch Ein- und Ausschalten des Ausgangssignals eines Wechselsignalgenerators amplitudenmoduliert wird.

5. Verfahren, nach einem der Ansprüche 1 bis 4, bei dem die Wechselfeldmodulationsfrequenz f_{MOD} vorzugsweise konstant und vorzugsweise im Bereich 1Hz ≤ f_{MOD} ≤ 1kHz gewählt wird.

6. Verfahren, nach einem der Ansprüche 1 bis 5, bei dem die Trägerfrequenz fₒ des Wechselfeldes im Bereich zwischen 1kHz (eingeschlossen) und Mikrowellenfrequenzen liegt, im Mikrowellenbereich vorzugsweise über 0,5GHz (eingeschlossen), darunter vorzugsweise zwischen 1kHz und 1MHz (je eingeschlossen), hier weiter bevorzugterweise zwischen 10kHz und 500kHz (je eingeschlossen).

7. Verfahren nach einem der Ansprüche 1 bis 6, bei dem das Plasma zwischen mindestens zwei Elektroden erzeugt wird und mindestens eine der Elektroden gegen den Plasmaentladungsraum hin dielektrisch umhüllt wird.

8. Verfahren nach einem der Ansprüche 1 bis 7, bei dem das Plasma zwischen mindestens zwei Elektroden erzeugt wird und bezüglich des zwischen den Elektroden liegenden Plasmaentladungsraumes, hinter einer der Elektroden, ein Gaseinlass angeordnet wird, vorzugsweise in Form mindestens einer Gaseinlassbrause, weiter vorzugsweise mit letzterer nachgeschalteter, gitterartiger Gasfeinverteilanordnung.

9. Verfahren nach einem der Ansprüche 1 bis 8, bei dem die Amplitudenmodulation des elektromagnetischen Wechselfeldes durch Pulsen erzeugt wird und die Pulslänge 10% bis 90% der Pulsrepetitionsperiode beträgt, vorzugsweise ca. 50%.

10. Verfahren nach einem der Ansprüche 1 bis 9, bei dem als Substrat ein nicht planes Substrat beschichtet wird, vorzugsweise mit der Form eines Reflektors.

11. Verfahren nach einem der Ansprüche 1 bis 10, bei dem als Substrat ein Substrat mit einer Metalloberfläche, wie einer Aluminiumoberfläche, beschichtet wird.

12. Verfahren nach einem der Ansprüche 1 bis 11, bei dem mindestens eine der folgenden Silizium-organischen Verbindungen eingesetzt wird:
Siloxane, Alkyl-/Alkoxy-Silane, insbesondere dabei Hexamethyl-DiSiloxan bzw. DiEthoxy-DiMethyl-Silan.

13. Verfahren nach einem der Ansprüche 1 bis 12, bei dem die Verbindung Hexamethyl-DiSiloxan umfasst, mindestens in überwiegendem Anteil.

14. Verfahren nach einem der Ansprüche 1 bis 13, bei dem vor der Schutzbeschichtung das Substrat metallbeschichtet wird, bevorzugterweise aluminiumbeschichtet, und dies durch Sputtern.

15. System für die Schutzbeschichtung von Substraten mittels Plasmapolymerisation, bestehend aus einer Beschichtungsanlage mit einer Vakuumkammer, einer Quellenanordnung, die in der Kammer, zur Erzeugung eines Plasmas, ein gleichspannungsfreies, periodisch amplitudenmoduliertes elektromagnetisches Wechselfeld erzeugt, einer an die Kammer angeschlossenen Pumpenanordnung sowie einer gesteuerten Gaseinlassanordnung, die mit einer Gasbehälteranordnung verbunden ist, welche eine siliziumorganische Verbindung enthält.

16. System nach Anspruch 15, bei dem die Gasbehälteranordnung (17) eine flüssige Silizium-organische Verbindung enthält.

17. System nach einem der Ansprüche 15 oder 16, bei dem die Quellenanordnung umfasst:
Einen amplitudenmodulierten Wechselsignalgenerator (11) oder mindestens zwei Wechselsignalgeneratoren (11a, 11b) unterschiedlicher Signalamplitude, deren Ausgänge getaktet zur Plasmaerzeugung aufgeschaltet werden, oder mindestens einen Wechselsignalgenerator (11c), dessen Ausgang getaktet über unterschiedliche Leistungseinkopplungsorgane in die Kammer, zur Erzeugung des Plasmas, geschaltet ist.

18. System nach einem der Ansprüche 15 bis 17, bei dem die Gasbehälteranordnung Behältnisse (17) mit mindestens einer der folgenden Verbindungen umfasst:
Siloxane, Alkyl-/Alkoxy-Silane, insbesondere Hexamethyl-DiSiloxan bzw. DiEthoxy-DiMethyl-Silane.

19. System nach einem der Ansprüche 15 bis 18, bei dem die Gasbehälteranordnung (17) als Silizium-organische Verbindung mindestens nahezu ausschliesslich Hexamethyl-DiSiloxan enthält.

20. System nach einem der Ansprüche 15 bis 19, bei dem die Quellenanordnung ausgangsseitig ein zwischen nahezu Null und vorgegebenem Amplitudenverlauf amplitudenmoduliertes Wechselsignal (m₁) erzeugt.

21. System nach einem der Ansprüche 15 bis 20, bei dem die Quellenanordnung ausgangsseitig ein mit vorzugsweise konstanter Modulationsfrequenz f_{MOD} amplitudenmoduliertes, elektromagnetisches Wechselsignal erzeugt, bevorzugterweise mit einer Frequenz 1Hz < f_{MOD} < 1kHz.

22. System nach einem der Ansprüche 15 bis 21, bei dem die Quellenanordnung ausgangsseitig ein amplitudenmoduliertes, elektromagnetisches Wechselsignal mit einer Trägerfrequenz fₒ erzeugt, zwischen 1kHz (eingeschlossen) und Mikrowellenfrequenzen, im Mikrowellenbereich vorzugsweise über 0,5GHz (eingeschlossen), darunter vorzugsweise zwischen 1kHz und 1MHz (je eingeschlossen), dabei vorzugsweise zwischen 10kHz und 500kHz (je eingeschlossen).

23. System nach einem der Ansprüche 15 bis 22, bei welchem das Plasma mittels mindestens zweier Elektroden (5, 7, 9) in der Vakuumkammer erzeugt wird und mindestens die eine der Elektroden (5) gegen den Plasmaentladungsraum (V) hin mit einer dielektrischen Beschichtung (24) versehen ist.

24. System nach einem der Ansprüche 15 bis 23, bei welchem das Plasma zwischen mindestens zwei Elektroden (5, 7, 9) erzeugt wird und mindestens eine der Elektroden (5) durch einen Elektrodenstab gebildet ist, der bevorzugterweise dielektrisch umhüllt ist.

25. System nach einem der Ansprüche 15 bis 24, bei dem die Gaseinlasseinrichtung in der Kammer mindestens eine brauseartige Auslasseinrichtung (16) umfasst, welche vorzugsweise stromab über eine gitterförmige Gasverteileinrichtung (16b) wirkt.

26. System nach einem der Ansprüche 15 bis 25, bei welchem das Plasma zwischen mindestens zwei Elektroden (5, 7, 9) erzeugt wird und mit Bezug auf eine der Elektroden (5) eine Gaseinlasseinrichtung (16) dem Plasmaentladungsraum (V) gegenüberliegend vorgesehen ist.

27. System nach einem der Ansprüche 15 bis 26, mit einem zu beschichtenden Substrat (26), bei dem das Substrat nicht plan ist, sondern vorzugsweise die Form eines Reflektors aufweist.

28. System nach einem der Ansprüche 15 bis 27, bei dem ein Substrathalter (28) vorgesehen ist, der elektrisch isoliert an der Kammer (1) angeordnet ist, um das Substrat potentialschwebend im Entladungsraum zu haltern.

29. System nach einem der Ansprüche 15 bis 28, mit einem zu beschichtenden Substrat (26), bei dem das Substrat eine Metalloberfläche aufweist, wie eine Aluminiumoberfläche.

30. System nach einem der Ansprüche 15 bis 29, bei dem die Gaseinlassanordnung sowie die Pumpenanordnung so in die Vakuumkammer münden, dass ein Gasfluss im wesentlichen in Richtung der zwischen mindestens zwei Elektroden erzeugten Plasmaentladung erfolgt.

## Claims

1. Process for protective coating of substrates by means of plasma polymerisation with at least one gaseous silicon organic compound, in which a plasma is generated in a vacuum chamber by means of a DC-free electromagnetic alternating field, a gas is supplied with the compound to generate the coating and by periodic amplitude modulation of the alternating field the formation of powdery components on the protective coating is largely prevented.

2. Process according to claim 1 in which the electromagnetic alternating field is generated according to one or by combination according to at least two of the following methods:
a) by amplitude modulation of an alternating signal generator,
b) by cycled connection of at least two alternating signal generators of different signal amplitude,
c) by cycled switching of the alternating signal coupling of an alternating signal generator into the vacuum chamber.

3. Process according to any of claims 1 or 2, in which the coating rate is set by means of at least one of the following process parameters:
- supplied electrical power,
- pressure and/or flow of the gaseous silicon organic compound,
- carrier frequency of an alternating signal generating the amplitude-modulated alternating field.

4. Process according to any of claims 1 to 3, in which the alternating field is amplitude-modulated by connecting and disconnecting the output signal of an alternating signal generator.

5. Process according to any of claims 1 to 4, in which the alternating field modulation frequency f_{MOD} is selected preferably constant and preferably in the range 1 Hz ≤ f_{MOD} ≤ 1 kHz.

6. Process according to any of claims 1 to 5, in which the carrier frequency f₀ of the alternating field lies in the range between 1 kHz (inclusive) and microwave frequencies, in the microwave frequency range preferably above 0.5 GHz (inclusive), here preferably between 1 kHz and 1 MHz (each inclusive), here further preferably between 10 kHz and 500 kHz (each inclusive).

7. Process according to any of claims 1 to 6, in which the plasma is generated between at least two electrodes and at least one of the electrodes is dielectrically sheathed against the plasma discharge chamber.

8. Process according to any of claims 1 to 7 in which the plasma is generated between at least two electrodes and arranged behind one of the electrodes, with regard to the plasma discharge chamber lying between the electrodes, is a gas inlet preferably in the form of at least one gas inlet spray nozzle, further preferably with grid-like gas fine distribution device connected after the latter.

9. Process according to any of claims 1 to 8, in which the amplitude modulation of the electromagnetic alternating field is generated by pulses and the pulse length amounts to 10% to 90% of the pulse repetition period, preferably approximately 50%.

10. Process according to any of claims 1 to 9, in which as a substrate, a non-flat substrate preferably in the form of a reflector is coated.

11. Process according to any of claims 1 to 10 in which as a substrate, a substrate with a metal surface such as an aluminium surface is coated.

12. Process according to any of claims 1 to 11, in which at least one of the following silicon organic compounds is used:
siloxane, alkyl/alkoxy-silane, in particular here hexamethyl-disiloxane or diethoxy-dimethyl-silane.

13. Process according to any of claims 1 to 12, in which the compound contains hexamethyl-disiloxane at least for the majority part.

14. Process according to any of claims 1 to 13 in which before the protective coating, the substrate is metal-coated, preferably aluminium-coated, by sputtering.

15. System for the protective coating of substrates by means of plasma polymerisation, consisting of a coating plant with a vacuum chamber, a source arrangement which generates a DC-free periodically amplitude-modulated electromagnetic alternating field in the chamber to generate a plasma, a pump arrangement connected to the chamber and a controlled gas inlet arrangement which is connected with a gas container device containing a silicon organic compound.

16. System according to claim 15 in which the gas container device (17) contains a liquid silicon organic compound.

17. System according to any of claims 15 or 16 in which the source arrangement comprises:
an amplitude-modulated alternating signal generator (11) or at least two alternating signal generators (11a, 11b) of different signal amplitude, the outputs of which can be switched cycled to generate plasma, or at least one alternating signal generator (11b), the output of which can be switched cycled via different power coupling elements into the chamber to generate the plasma.

18. System according to any of claims 15 to 17 in which the gas container device comprises containers (17) with at least one of the following compounds:
siloxane, alkyl/alkoxy-silane, in particular here hexamethyl-disiloxane or diethoxy-dimethyl-silane.

19. System according to any of claims 15 to 18 in which the gas container device (17) contains as a silicon organic compound at least almost exclusively hexamethyl-disiloxane.

20. System according to any of claims 15 to 19 in which the source arrangement at the output side generates an amplitude-modulated alternating signal (m₁) between almost zero and the prespecified amplitude development.

21. System according to any of claims 15 to 20 in which the source arrangement at the output side generates an electromagnetic alternating signal amplitude-modulated with preferably constant modulation frequency f_{MOD}, preferably with a frequency 1 Hz < f_{MOD} < 1 kHz.

22. System according to any of claims 15 to 21 in which the source arrangement at the output side generates an amplitude-modulated electromagnetic alternating signal with a carrier frequency of f₀ between 1 kHz (inclusive) and microwave frequencies, in the microwave range preferably above 0.5 GHz (inclusive), here preferably between 1 kHz and 1 MHz (each inclusive), here preferably between 10 kHz and 500 kHZ (each inclusive).

23. System according to any of claims 15 to 22 in which the plasma is generated by means of at least two electrodes (5, 7, 9) in the vacuum chamber and at least one of the electrodes (5) is fitted with a dielectric coating (24) against the plasma discharge chamber (V).

24. System according to any of claims 15 to 23 in which the plasma is generated between at least two electrodes (5, 7, 9) and at least one of the electrodes (5) is formed by an electrode rod which is preferably dielectrically sheathed.

25. System according to any of claims 15 to 24 in which the gas inlet device in the chamber comprises at least a spray nozzle-like outlet device (16) which preferably acts downstream via a grid-like gas distribution device (16b).

26. System according to any of claims 15 to 25 in which the plasma is generated between at least two electrodes (5, 7, 9) and a gas inlet device (16) is provided opposite the plasma discharge chamber (V) with regard to one of the electrodes (5).

27. System according to any of claims 15 to 26 with a substrate (26) to be coated, in which the substrate is not flat but preferably has the form of a reflector.

28. System according to any of claims 15 to 27 in which a substrate holder (28) is provided which is arranged electrically insulated on the chamber (1) in order to hold the substrate potential-floating in the discharge chamber.

29. System according to any of claims 15 to 28 with a substrate (26) to be coated, in which the substrate has a metal surface such as an aluminium surface.

30. System according to any of claims 15 to 29 in which the gas inlet device and the pump arrangement open into the vacuum chamber so that a gas flow occurs essentially in the direction of the plasma discharge generated between at least two electrodes.

## Revendications

1. Procédé pour appliquer un revêtement protecteur sur des substrats à l'aide d'une polymérisation par plasma avec au moins un composé organosilicié gazeux, selon lequel dans une chambre à vide, on génère un plasma à l'aide d'un champ électromagnétique alternatif sans tension continue, on amène un gaz contenant le composé afin de produire le revêtement et grâce à une modulation d'amplitude périodique du champ alternatif, on empêche dans une très large mesure la formation de parties pulvérulentes sur la couche protectrice.

2. Procédé selon la revendication 1, selon lequel on génère le champ électromagnétique alternatif de l'une des manières suivantes ou d'au moins deux manières suivantes combinées :
a) grâce à la modulation d'amplitude d'un générateur de signaux alternatifs,
b) grâce à l'intervention synchronisée d'au moins deux générateurs de signaux alternatifs d'amplitudes de signaux différentes,
c) grâce à la commutation synchronisée de l'injection de signaux alternatifs dans la chambre à vide à partir du générateur de signaux alternatifs.

3. Procédé selon la revendication 1 ou 2, selon lequel la vitesse d'application de revêtement est réglée à l'aide de l'un au moins des paramètres de procédé suivants:
- puissance électrique fournie,
- pression et/ou écoulement du composé organosilicié gazeux,
- fréquence porteuse d'un signal alternatif générant le champ alternatif à modulation d'amplitude.

4. Procédé selon l'une des revendications 1 à 3, selon lequel le champ alternatif est modulé en amplitude par le déclenchement et l'interruption du signal de sortie d'un générateur de signaux alternatifs.

5. Procédé selon l'une des revendications 1 à 4, selon lequel on choisit une fréquence de modulation de champ alternatif f_{MOD} de préférence constante et de préférence dans la plage 1 Hz ≤ f_{MOD} ≤ 1 kHz.

6. Procédé selon l'une des revendications 1 à 5, selon lequel la fréquence porteuse fₒ du champ alternatif est située entre 1 kHz (inclus) et les hyperfréquences, dans la plage des hyperfréquences, elle est de préférence supérieure à 0,5 GHz (inclus) et au-dessous, elle va de préférence de 1 kHz à 1 MHz (inclus), et plus spécialement de 10 kHz à 500 kHz (inclus).

7. Procédé selon l'une des revendications 1 à 6, selon lequel le plasma est produit entre au moins deux électrodes et l'une au moins des électrodes est pourvue d'une enveloppe diélectrique en direction de l'espace de décharge de plasma.

8. Procédé selon l'une des revendications 1 à 7, selon lequel le plasma est produit entre au moins deux électrodes et on prévoit derrière l'une des électrodes, par rapport à l'espace de décharge de plasma situé entre les électrodes, un orifice d'admission de gaz de préférence sous la forme d'au moins un gicleur d'admission de gaz, de préférence avec un dispositif de diffusion fine de gaz en forme de grille, en aval dudit gicleur.

9. Procédé selon l'une des revendications 1 à 8, selon lequel la modulation d'amplitude du champ électromagnétique alternatif est générée par application d'impulsions et la durée d'impulsion est de 10 % à 90 % de la période de répétition d'impulsions, de préférence d'environ 50 %.

10. Procédé selon l'une des revendications 1 à 9, selon lequel le substrat revêtu est un substrat non plat, de préférence en forme de réflecteur.

11. Procédé selon l'une des revendications 1 à 10, selon lequel le substrat revêtu est un substrat présentant une surface métallique telle qu'une surface en aluminium.

12. Procédé selon l'une des revendications 1 à 11, selon lequel on utilise l'un au moins des composés organosiliciés suivants :
siloxanes, alkyl-/alcoxysilanes, en particulier hexaméthyldisiloxane ou diéthoxydiméthylsilane.

13. Procédé selon l'une des revendications 1 à 12, selon lequel le composé contient de l'hexaméthyldisiloxane, au moins dans une proportion prépondérante.

14. Procédé selon l'une des revendications 1 à 13, selon lequel avant l'application du revêtement protecteur, on applique sur le substrat un revêtement métallique, de préférence un revêtement en aluminium, par pulvérisation cathodique.

15. Système pour appliquer un revêtement protecteur sur des substrats à l'aide d'une polymérisation par plasma, composé d'une installation d'application de revêtement comportant une chambre à vide, un dispositif source qui génère dans la chambre, pour produire un plasma, un champ électromagnétique alternatif sans tension continue et à modulation d'amplitude périodique, un dispositif formant pompe raccordé à la chambre et un dispositif d'admission de gaz commandé qui est relié à un dispositif formant réservoir de gaz contenant un composé organosilicié.

16. Système selon la revendication 15, dans lequel le dispositif formant réservoir de gaz (17) contient un composé organosilicié liquide.

17. Système selon la revendication 15 ou 16, dans lequel le dispositif source comprend :
un générateur de signaux alternatifs à modulation d'amplitude (11) ou au moins deux générateurs de signaux alternatifs (11a, 11b) d'amplitudes de signaux différentes, dont les sorties sont commutées de manière synchronisées en vue de produire du plasma, ou au moins un générateur de signaux alternatifs (11c) dont la sortie est commutée de manière synchronisée par l'intermédiaire de différents organes d'injection de puissance dans la chambre, en vue de produire le plasma.

18. Système selon l'une des revendications 15 à 17, dans lequel le dispositif formant réservoir de gaz comprend des récipients (17) contenant l'un au moins des composés suivants :
siloxanes, alkyl-/alcoxysilanes, en particulier hexaméthyldisiloxane ou diéthoxydiméthylsilanes.

19. Système selon l'une des revendications 15 à 18, dans lequel le dispositif formant réservoir de gaz (17) contient comme composé organosilicié au moins presque uniquement de l'hexaméthyldisiloxane.

20. Système selon l'une des revendications 15 à 19, dans lequel le dispositif source génère, côté sortie, un signal alternatif (m₁) à amplitude modulée entre environ zéro et une courbe d'amplitude prédéfinie.

21. Système selon l'une des revendications 15 à 20, dans lequel le dispositif source génère, côté sortie, un signal électromagnétique alternatif à amplitude modulée à une fréquence de modulation f_{MOD} de préférence constante, de préférence à une fréquence 1 Hz < f_{MOD} < 1 kHz.

22. Système selon l'une des revendications 15 à 21, dans lequel le dispositif source génère, côté sortie, un signal électromagnétique alternatif à amplitude modulée, avec une fréquence porteuse fₒ située entre 1 kHz (inclus) et les hyperfréquences, dans la plage des hyperfréquences, elle est de préférence supérieure à 0,5 GHz (inclus) et au-dessous, elle va de préférence de 1 kHz à 1 MHz (inclus) et de préférence entre 10 kHz et 500 kHz (inclus).

23. Système selon l'une des revendications 15 à 22, dans lequel le plasma est produit dans la chambre à vide à l'aide d'au moins deux électrodes (5, 7, 9) et l'une au moins des électrodes (5) est pourvue d'un revêtement diélectrique (24) en direction de l'espace de décharge de plasma (V).

24. Système selon l'une des revendications 15 à 24, dans lequel le plasma est généré entre au moins deux électrodes (5, 7, 9) et l'une au moins des électrodes (5) est formée par une électrode en baguette qui est de préférence recouverte d'une enveloppe diélectrique.

25. Système selon l'une des revendications 15 à 24, dans lequel le dispositif d'admission de gaz prévu dans la chambre comprend au moins un dispositif d'éjection de gaz en forme de gicleur (16) qui agit de préférence en aval par l'intermédiaire d'un dispositif de distribution de gaz en forme de grille (16b).

26. Système selon l'une des revendications 15 à 25, dans lequel le plasma est produit entre au moins deux électrodes (5, 7, 9) et en ce qu'on prévoit un dispositif d'admission de gaz (16) à l'opposé de l'espace de décharge de plasma (V), par rapport à l'une des électrodes (5).

27. Système selon l'une des revendications 15 à 26, avec un substrat à revêtir (26), dans lequel le substrat n'est pas plat mais a de préférence la forme d'un réflecteur.

28. Système selon l'une des revendications 15 à 27, dans lequel on prévoit un porte-substrat (28) qui est disposé, isolé électriquement, au niveau de la chambre (1) afin de maintenir le substrat à un potentiel flottant dans l'espace de décharge.

29. Système selon l'une des revendications 15 à 28, avec un substrat à revêtir (26), dans lequel le substrat présente une surface métallique telle qu'une surface en aluminium.

30. Système selon l'une des revendications 15 à 29, dans lequel le dispositif d'admission de gaz ainsi que le dispositif formant pompe débouchent dans la chambre à vide de telle sorte qu'un écoulement de gaz ait lieu globalement dans le sens de la décharge de plasma générée entre au moins deux électrodes.
